# EUROPEAN PATENT APPLICATION

(11) **EP 4 807 741 A1**
(43) Date of publication of application: **16.09.2026**
(21) Application number: 25163700.5
(22) Date of filing: 14.03.2025
(51) Int. Cl.: G11C 5/06, H01L 21/768, H01L 23/00

(54) **A METHOD FOR FORMING AN INTERCONNECT STRUCTURE**

(71) Applicant: Imec VZW, 3001 Leuven (BE)
(72) Inventor: SOULIE, Jean-Philippe, 1910 Kampenhout (BE); ADELMANN, Hanns Christoph, 3012 Wilsele (BE); CHEW, Soon Aik, 3001 Heverlee (BE); PARK, Seongho, 3001 Heverlee (BE); TOKEI, Zsolt, 3000 Leuven (BE)
(74) Representative: Lind Edlund Kenamets Intellectual Property AB

(57) **Abstract**

There is provided a method for forming an interconnect structure for an integrated circuit device, the method comprising:
forming a workpiece for a second interconnect layer on a sacrificial substrate, wherein the workpiece comprises at least a first workpiece metal layer epitaxially grown on a growth surface of the sacrificial substrate;
bonding the workpiece to an initial interconnect structure of a device wafer, the initial interconnect structure comprising a first interconnect layer surrounded by an interlayer dielectric layer;
subsequent to the bonding, removing the sacrificial substrate from the first workpiece metal layer; and
patterning the workpiece comprising the first workpiece metal layer to form a second interconnect layer over the first interconnect layer.

## Description

### TECHNICAL FIELD

The present invention generally relates to a method for forming an interconnect structure for an integrated circuit device

### BACKGROUND

In interconnect structures of integrated circuits (ICs), the resistivity of the conducting metal significantly impacts the overall resistance of metal lines and vias. For many metals, the resistivity is primarily determined by grain boundary scattering. Thus, reducing an occurrence of grain boundaries in metal films for interconnect structure fabrication may be anticipated to reduce metal line and via resistances.

Epitaxy of metals is well-documented in the literature, with various deposition processes such as physical vapor deposition (PVD) and chemical vapor deposition (CVD) being capable of producing monocrystalline metallic films. However, a critical requirement for obtaining monocrystalline metal films is a monocrystalline substrate.

Current interconnect fabrication approaches are typically based on metallic films deposited onto an amorphous dielectric, e.g., the interlayer dielectric (ILD) of the interconnect structure. In this case, due to the random orientation of individual crystal nuclei, polycrystalline films with a high density of grain boundaries, and thus high resistivity, are invariably obtained. This becomes an increasing issue as the device dimensions are scaled down.

### SUMMARY

In view of the above, it is in object to provide improvements over current methods for interconnect structure fabrication. More specifically, it is an object to enable fabrication of interconnect structures comprising interconnects with a reduced occurrence of grain boundaries, and thus reduced resistivity. Further and alternative objects may be understood from the following.

According to an aspect of the present invention, there is provided a method for forming an interconnect structure for an integrated circuit device, the method comprising:
forming a workpiece for a second interconnect layer on a sacrificial substrate, wherein the workpiece comprises at least a first workpiece metal layer epitaxially grown on a growth surface of the sacrificial substrate;
bonding the workpiece to an initial interconnect structure of a device wafer, the initial interconnect structure comprising a first interconnect layer surrounded by an interlayer dielectric layer;
subsequent to the bonding, removing the sacrificial substrate from the first workpiece metal layer; and
patterning the workpiece comprising the first workpiece metal layer to form a second interconnect layer over the first interconnect layer.

The method is an efficient and practical process flow based on layer transfer, allowing integrating high quality epitaxial metal in an interconnect structure. By epitaxially growing at least a first workpiece metal layer of a workpiece on a sacrificial substrate, and subsequently bonding the workpiece to the device wafer comprising the first (metal) interconnect layer, the first workpiece metal layer may be formed with a considerably reduced occurrence of grain boundaries relative to had the first workpiece metal layer been directly deposited on the first interconnect layer in a conventional manner. That the first workpiece metal layer is epitaxially grown on the growth surface of the sacrificial substrate implies that the sacrificial substrate is crystalline (advantageously monocrystalline). By contrast, epitaxial growth of metal on the surface of the (amorphous) interlayer dielectric (ILD) layer of device wafer would be infeasible.

Due to its epitaxial structure, the second (metal) interconnect layer patterned in the first workpiece metal layer may thus present a reduced resistivity. A further benefit is that the first workpiece metal layer, due to being epitaxially grown on the epitaxial substrate, may exhibit reduced orientation-dependent anisotropic etching effects, which enables reduced line roughness of the patterned features of the second interconnect layer. This improvement can have a further substantial impact on both interconnect resistance and yield.

In some embodiments, the sacrificial substrate is monocrystalline. A monocrystalline sacrificial substrate enables a growth of a high quality epitaxial metal layer, in particular a monocrystalline metal layer.

In some embodiments, the sacrificial substrate may be an epitaxial substrate. That is, the sacrificial substrate may be epitaxially grown on a growth wafer.

In some embodiments, the first workpiece metal layer is monocrystalline. The first workpiece metal layer may thus be formed without grain boundaries, enabling low resistivity and minimizing orientation-dependent anisotropic etching effects during patterning.

In some embodiments, the first workpiece metal layer is a layer of Ru, Mo, W, Co, Ni, Cu, Rh, Ir, NiAl, PtCoO₂, or PdCoO₂. These are all examples of metals that may be grown to form high quality epitaxial metal layers. A further benefit is that they are compatible with existing direct-metal etch patterning processes.

In some embodiments, the sacrificial substrate is an AlN substrate or an GaN/AlN substrate. AlN and GaN/AlN substrates of high quality may be epitaxially grown with a crystallographic structure suitable for epitaxial growth of a number of metals with a thickness suitable for interconnect layers.

In some embodiments, the sacrificial substrate is epitaxially grown on a crystallographic plane with Miller indices 111 of a Si wafer. A Si (111) wafer enables growth of a high quality, advantageously monocrystalline, AlN or GaN/AlN substrate, in turn facilitating growth of a high quality, advantageously monocrystalline metal layer, such as of Ru, Mo or W.

In some embodiments, the sacrificial substrate is an SrTiO₃ (STO) substrate or an MgO substrate. Such substrates may be epitaxially grown on for instance a Si (100) wafer.

In some embodiments, the sacrificial substrate is an (epitaxial) Ge or SiGe substrate. Such substrates may be epitaxially grown on Si (100) or Si (111).

In some embodiments, the method further comprises depositing a metal bonding layer over the initial interconnect structure of the device wafer, wherein the workpiece subsequently is bonded to the metal bonding layer.

Thereby, the top surface of the device wafer (defined by the top surface of the initial interconnect structure) may be metal-terminated. This enables a metal-metal bonding of the workpiece to the interconnect structure of the device wafer. Moreover, an available metal bonding surface for the workpiece may be increased.

To facilitate the bonding, the bonding metal layer may advantageously be of a same metal as the first workpiece metal layer and/or a second workpiece metal layer of the workpiece (discussed above).

In some embodiments, the first interconnect layer and the interlayer dielectric layer are exposed at a top surface of the initial interconnect structure, and the method further comprising depositing a conductive adhesion layer to cover the first interconnect layer and the interlayer dielectric layer, wherein the metal bonding layer subsequently is deposited on the conductive adhesion layer.

Thereby, the metal bonding layer may be formed also of metals with poorer adhesion to interlayer dielectrics.

The metal bonding layer and/or the conductive adhesion layer may be especially useful in cases of a lower feature density of the first interconnect layer, such as where the first interconnect layer defines vias.

In some embodiments, patterning the workpiece comprises:
patterning initial metal lines in the workpiece; and
partially etching back the initial metal lines while masking the initial metal lines in via locations, to form metal lines and vias, wherein each via is formed in a via location, on top of a metal line.

The first workpiece metal layer may thus be patterned to form both metal lines and vias on top. Hence, both metal lines and vias may be formed following a single layer transfer.

This approach may be particularly suitable in embodiments where the first interconnect layer of the device wafer comprises vias. Thus, at least a subset of the metal lines may be formed on top of, and in contact with, a via of the first interconnect layer

In some embodiments, the workpiece further comprises a layer stack of the first workpiece metal layer, a conductive interfacial layer deposited on the first workpiece metal layer and a second workpiece metal layer epitaxially grown on the conductive interfacial layer, and wherein:
bonding the workpiece to the initial interconnect structure of the device wafer comprises directly bonding the second workpiece metal layer to the initial interconnect structure of the device wafer; and
the interfacial layer is used as an etch stop layer when etching back the initial metal lines such that the metal lines are formed in the second workpiece metal layer and the vias are formed in the first workpiece metal layer.

The workpiece may thus be formed as a tri-layered structure, comprising first and second epitaxial metal layers (advantageously of a same metal, and, optionally, both monocrystalline), wherein the interfacial layer may provide an etch contrast such that the etch back of the initial metal lines may be precisely stopped to form metal lines with a target height.

In some embodiments, the first interconnect layer of the device wafer comprises metal lines defining a top surface of the initial interconnect structure of the device wafer;
bonding the workpiece to the initial interconnect structure comprises bonding the first workpiece metal layer to the top surface of the initial interconnect structure; and
patterning the workpiece comprises patterning vias in the first workpiece metal layer.

Compared to vias, metal lines may provide a top surface with a relatively high metal-to-ILD ratio, hence facilitating hybrid binding of the workpiece to the metal lines and ILD layer of the device wafer, i.e., without any preceding deposition of a metal bonding layer and adhesion layer. The first workpiece metal layer of the workpiece (which here is absent of interfacial and second workpiece metal layers) is subsequently patterned to define vias directly on top of the metal lines of the first interconnect layer.

In some embodiments, the method further comprises depositing interlayer dielectrics to surround the second interconnect layer. The second interconnect layer may thus be completed by surrounding the second interconnect layer (e.g., metal lines and/or vias) with ILD.

In some embodiments, the ILD is deposited to fill trenches between the patterned interconnects.

In some embodiments, the ILD may be deposited by pinch-off deposition, such that upper portions of trenches between the patterned interconnects are filled with ILD and air gaps are formed underneath.

In some embodiments, the method further comprises, subsequent to forming the second interconnect layer:
forming a further workpiece for a third interconnect layer on a further sacrificial substrate, wherein the further workpiece comprises at least a first workpiece metal layer epitaxially grown on a growth surface of the further sacrificial substrate;
bonding the further workpiece to the device wafer;
subsequent to the bonding, removing the further sacrificial substrate from the first workpiece metal layer of the further workpiece; and
patterning the further workpiece comprising the first workpiece metal layer to form the third interconnect layer on top of the second top interconnect layer.

The layer transfer process set out above may thus be repeated to form a further (third) interconnect layer on top of the second interconnect layer, with corresponding benefits. Any discussion, features, examples and advantages discussed above with reference to the forming, bonding and patterning of the workpiece, etc., applies correspondingly to this repetition of the layer transfer process. Further, any discussion of the sacrificial substrate in the above applies correspondingly to the further sacrificial substrate.

### BRIEF DESCRIPTION OF THE DRAWINGS

The above, as well as additional objects, embodiments, features and effects of the present invention, may be better understood through the following illustrative and non-limiting detailed description, with reference to the appended drawings. In the drawings like reference numerals will be used for like elements unless stated otherwise.
Fig. 1a-k illustrate various stages of a method for forming an interconnect structure, in accordance with some embodiments.
Fig. 2a-c illustrate a variation of the method in Fig. 1a-k, in accordance with some embodiments.
Fig. 3a-e illustrate various stages of a further method for forming an interconnect structure, in accordance with some embodiments.

### DETAILED DESCRIPTION

In the following, various methods for forming an interconnect structure for an integrated circuit device, involving a transfer and bonding of an epitaxial metal layer to a device wafer will be described with reference to the drawings. The drawings are only schematic and the relative dimensions of illustrated elements, such as layers, substrates, wafers or other structures, may be exaggerated and not drawn to scale. Rather the dimensions may be adapted for illustrational clarity and to facilitate understanding. Like fill patterns of features generally indicate that the features may be formed of like materials. When present in the figures, the indicated axes X and Y consistently refer to a horizontal direction and a vertical direction, respectively, with respect to the structure shown in the instant figure. As used herein, the term "horizontal" with respect to a given device structure refers to a direction parallel to a wafer or substrate (i.e., its main plane of extension) of, or supporting, the given device structure. Correspondingly, the term "vertical" with respect to the given device structure refers to a direction parallel to a normal direction to (the main plane of extension of) the wafer or substrate of the given device structure. In other words, "horizontal" and "vertical" refer respectively to in-plane and out-of-plane directions with respect to the wafer or substrate. Accordingly, terms indicating relative elevational arrangement of elements, such as "top", "upper", "bottom", "lower" and the like, are to be understood in relation to the Y direction relative to the wafer/substrate of the given device structure, unless stated otherwise. In the present disclosure, when an element (e.g. a layer or other structure) is referred to as being provided, arranged, formed, grown or deposited "on" another element, it can be directly on the other element or on one or more intermediate elements on the other element. Conversely, when an element is referred to as being "directly on" another element, there is no intermediate element and the element is thus provided, arranged, formed, grown or deposited in physical contact or abutment with the other element. In particular, epitaxial growth of a layer on a growth surface implies that the layer is grown in direct contact with (i.e., seeding from) the growth surface. In the present disclosure, when two elements are said to be "connected" or "interconnected" it is meant that the elements are electrically connected or coupled, directly or via one or more intermediate conductive structures (e.g., interconnects), unless stated otherwise. This applies correspondingly to the terms "bonded to". That is, two layers may be bonded directly (implying a mutual abutment, i.e., a direct bonding interface, between the layers), or indirectly (implying a bonding via one or more intermediate bonding layers).

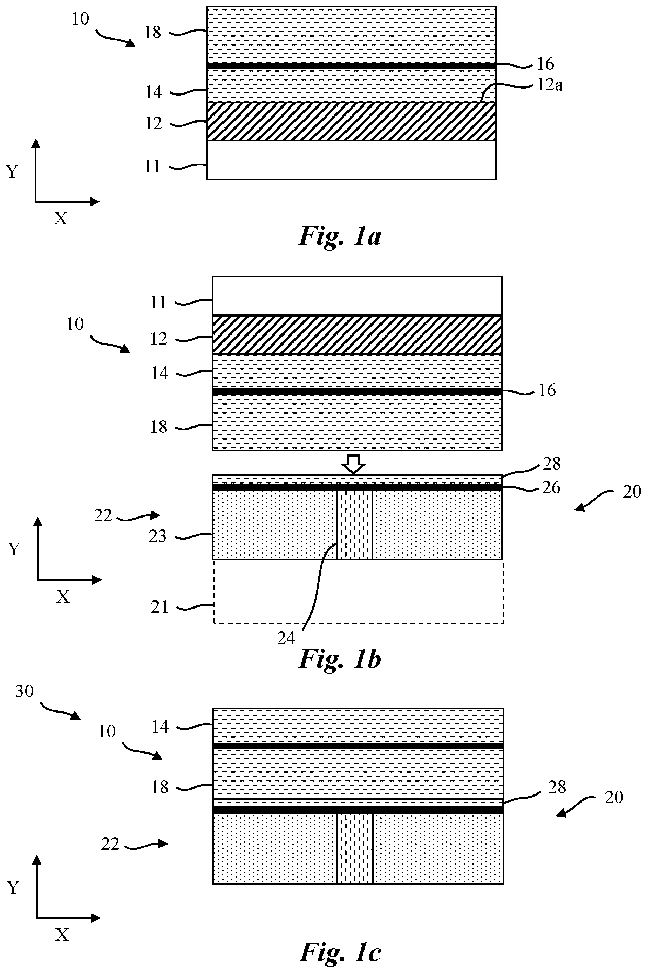

Fig. 1a depicts a workpiece 10 for an interconnect layer, in particular a second interconnect layer to be formed on top of a first interconnect layer of a device wafer, as set out in the following. In the present disclosure, the term "workpiece" is used to refer to an intermediate or precursor structure for an interconnect layer, that is to be further processed to form the interconnect layer. The term "layer structure" or "metal layer structure" may be used as alternatives to the term for "workpiece".

The workpiece 10 comprises a layer stack of a first workpiece metal layer 14, a second workpiece metal layer 18, and a conductive interfacial layer 16 interposing the first and second workpiece metal layers 14. For conciseness, the first and second workpiece metal layers 14 and 18 are hereinafter termed first and second metal layers 14, 18, respectively. The layer stack is formed on a sacrificial substrate 12. The first metal layer 14 is epitaxially grown on (seeding from) the growth surface 12a of the sacrificial substrate 12. The interfacial layer 16 is in turn deposited on (e.g., directly on) the first metal layer 14. The second metal layer 14 is in turn epitaxially grown on (e.g., directly on) the interfacial layer 16. The first and second metal layers 14, 18 are both epitaxial metal layers, typically of a same metal.

In the illustrated example, the sacrificial substrate 12 is an epitaxial sacrificial substrate 12, i.e., epitaxially grown on a growth (donor) wafer 11. Various choices of materials of the growth wafer 11, the sacrificial substrate 12 and the workpiece 10 are possible. In general, the sacrificial substrate 12 is to provide an epitaxial growth surface 12a of suitable crystallographic structure for the metal layer 14, 18 of the workpiece 10, to enable growth of high quality epitaxial metal layers 14, 18. The sacrificial substrate 12 and the first and second metal layer 14, 18 may advantageously each be substantially monocrystalline. The growth wafer 11 may in turn be of a composition so as to facilitate forming the sacrificial substrate 12 such that it may promote the epitaxial growth of the metal layers 14, 18.

For example, a monocrystalline AlN or GaN/AlN substrate 12 (which for instance may be epitaxially grown on a Si (111) wafer 11) may enable growing monocrystalline epitaxial Ru (001) layers with a resistivity consistent with bulk Ru resistivity for thicknesses of 30 nm and greater. In case of a GaN/AlN substrate 12, the growth surface 12a is defined by the GaN. An AlN or GaN/AlN layer substrate 12 may be formed with a thickness in a range of 100 nm to 1000 nm. Either of these combinations of wafer 11 and substrate 12 may be used to provide a suitable growth surface for epitaxial growth of other (monocrystalline) metal films, such as Ru, Mo or W. However, also other metal film materials and substrate / wafer combinations are possible. Further examples of materials of the metal layers 14, 18 include Co, Ni, Cu, Rh, Ir, NiAl, PtCoO₂, or PdCoO₂. Further examples of the substrate 12 and wafer 11 include a STO or MgO substrate on a Si (100) wafer, or a Ge or SiGe substrate on a Si (100) wafer or on a Si (111) wafer.

The sacrificial substrate 12, the first metal layer 14 and the second metal layer 18 may be grown by various epitaxial deposition processes, such as PVD or CVD. For example, the first and second metal layers 14, 18 may be grown by using a metalorganic precursor in combination with H₂ or O₂ as reactive gases. This is however merely one non-limiting example and any other deposition processes known in the industry and allowing epitaxial growth of metal on a suitable growth substrate may be used.

As will be understood from the following, the purpose of the interfacial layer 16 is to act as an etch stop layer in a subsequent patterning process applied to the workpiece 10. As implied by this use, the interfacial layer 16 is formed of a different material than the first and second metal layers 14, 18. The interfacial layer 16 should further be formed / adapted so as to allow a crystallographic structure or texture of the first metal layer 14 to be transferred to the second metal layer 18. That is, the interfacial layer 16 is to be deposited so as to be crystallographically coherent with the first and second metal layers 14, 18, i.e. it should not disturb their crystallographic structure. The interfacial layer 16 should in other words define a non-texture breaking layer. The interfacial layer 16 may be epitaxially grown, e.g. with a thickness less than its material-specific critical thickness. A non-epitaxial interfacial layer is however also possible, provided its thickness is sufficiently small. For example, the interfacial layer 16 may be formed of TiN or TaN, with a thickness of about 1 nm or less.

An alternative example to AlN/Si(111) and GaN/AlN/Si(111) is a c-plane sapphire (Al₂O₃ (0001)) wafer. However, it is noted that AlN or GaN/AlN may simplify the subsequent removal step of the sacrificial substrate 12 following the bonding processed discussed with reference to Fig. 1c.

In Fig. 1b, the growth wafer 11, supporting the sacrificial substrate 11 and the workpiece 10, is flipped and transferred to a top surface of a device wafer 20. The XY coordinate system is here (and in the subsequent figures) anchored to the device wafer 20 such that the vertical direction Y points in the normal direction to the device wafer 20, and thus opposite the normal direction to the wafer 11 and substrate 12.

The device wafer 20 may be a conventional CMOS device wafer comprising, for instance, a silicon wafer 21 (e.g., Si(100), bulk or SOI) and any additional layers typical for a CMOS device, such as an active device layer, local interconnects and gate layers, etc. processed thereon. The device wafer 20 may be a product wafer, i.e. a wafer on which the IC device is fabricated.

The device wafer 20 further comprises a preliminary or initial interconnect structure comprising (at least) a first interconnect layer 24 surrounded by an ILD layer 23. The first interconnect layer 24 and the ILD layer 23 may collectively define a first interconnect level 22 of the initial interconnect structure of the device wafer 20. The first interconnect level 22 and the first interconnect layer 24 may here also be referred to as top interconnect levels and layers, respectively, of the device wafer 20, where the term "top" signifies that they are the top-most interconnect level and layer, respectively, of the device wafer 20 (i.e., at the stage of the process depicted in Fig. 1b).

In the illustrated example, the first interconnect layer 24 is assumed to form a layer of contacts or vias. For ease of explanation, the same reference sign 24 may in the following be used to refer to either the first interconnect layer 24 or an individual via thereof. The vias 24 may for instance be the bottom-most vias ("V0" or "VINT") of the device wafer 20. As may be appreciated, the bottom-most vias of an interconnect structure may typically land on and contact the local interconnects or gates of the active devices. However, the vias 24 may more generally belong to any via layer ("Vx") of the device wafer 20.

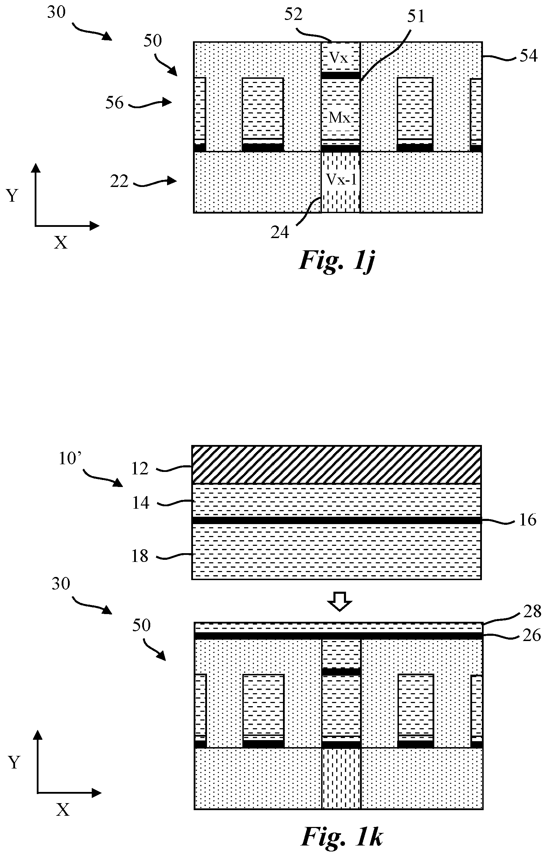

The first interconnect level 22 may be formed by a conventional back-end-of-line process, e.g., a damascene-based process. The ILD layer 23 may for example comprise SiO₂, and/or some other conventional low-k ILD material. The first interconnect layer 24 may for example be formed of or comprise (polycrystalline) W, or some other conventional polycrystalline CMOS compatible metal suitable for interconnect structures such as Al, Au, Cu, etc. However, as may be understood from the below discussion with reference to Fig. 1k, the first interconnect level 22 may also be formed by a preceding layer transfer and bonding process as set out herein, wherein the first interconnect layer 24 may be formed by an epitaxial metal, such as epitaxial, advantageously monocrystalline, Ru, Mo or W.

Regardless of how the first interconnect level 22 is formed, the top surface of the first interconnect level 22 is defined by the respective flush top surfaces of the first interconnect layer 24 and the ILD layer 23. The top surface of the first interconnect level 22 is hence at least in part formed by the amorphous (low-k) ILD layer 23, and only in part metallic. For this reason, among others, epitaxial growth of a metal layer on the first interconnect level 22 would not be viable.

As mentioned above, in the illustrated example, the first interconnect layer 24 is a via layer. Hence, the metallic surface area available for bonding is relatively small. Therefore, to facilitate the bonding of the workpiece 10 to the device wafer 20, a metal bonding layer 28 may as shown be deposited over the first interconnect level 22, to provide the device wafer 20 with a metal-terminated top surface, for bonding to the workpiece 10. The metal bonding layer 28 may be formed of a same metal as the second metal layer 18 (and the first metal layer 14). The metal bonding layer 28 may for example be a layer of Ru or Mo, deposited for instance by PVD. As the purpose of the metal bonding layer 28 is to facilitate the bonding, it may be formed as a relatively thin layer compared to the workpiece 10. For example, the metal bonding layer 28 may be formed with a thickness in a range of about 0.5 to 3 nm.

As some metals, such as Ru and Mo, may present a relatively poor adhesion to ILD materials, the deposition of the metal bonding layer 28 may as shown be preceded by depositing a conductive adhesion layer 26 on (e.g., directly on) the top surface of the first interconnect level 22. The top surfaces of the ILD 23 and the first interconnect/via layer 24 may hence be covered by the adhesion layer 26, wherein the metal bonding layer 28 subsequently may be deposited on the conductive adhesion layer 26. The adhesion layer 26 may for example be deposited by PVD or CVD. The adhesion layer 26 may for example be formed of a same material as the interfacial layer 16 of the workpiece 10 (e.g., TiN or TaN). However, other materials that may define adhesive and conductive layers are also possible. As may be appreciated, in case adhesion of the bonding layer 28 is not an issue, the adhesion layer 26 may be omitted.

In Fig. 1c, the workpiece 10 has been bonded to the device wafer 20, by means of a direct metal-metal bonding of the second metal layer 18 to the bonding layer 28 defining the top surface of the device wafer 20. Thus, the second metal layer 18 and the bonding layer 28 are brought into mutual abutment and then bonded to each other by forming a metal-to-metal bonding interface therebetween. As per se is known in the art, a cleaning step may be applied to the second metal layer 18 and the bonding layer 28 prior to the bonding, to achieve a higher quality bonding interface.

Subsequent to the bonding, the sacrificial substrate 12 and the growth wafer 11 have been removed from the first metal layer 14 of the workpiece 10, e.g., by a sequence of grinding/polishing and etching steps. In case of a AlN/Si(111) and GaN/AlN/Si(111) substrate/wafer, the AlN/Si (111) interface can be used for etch-stop detection.

Following the wafer/substrate removal step, a processed device structure 30 has been obtained, comprising the workpiece 10 (comprising a pair of epitaxial metal layers 14, 18 and a conductive interfacial layer 16) on top of the initial device wafer 20. The top (top-most) layer of the resulting device structure 30 is here formed by the first metal layer 14. At this stage, an optional post-transfer anneal may be used to further improve the bonding and the crystallinity of the workpiece 10.

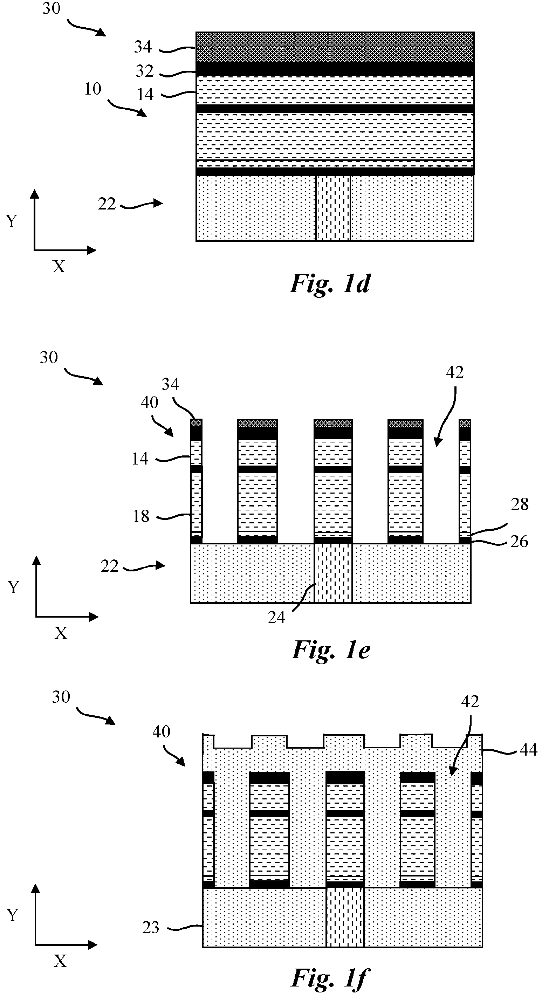

In Fig. 1d, an initial step of a patterning process for the workpiece 10 has been performed by forming a hard mask 34 over the first metal layer 14 of the workpiece 10. The hard mask 34 may be formed by any conventional hard mask material, such as a nitride-, oxide-, and/or carbide-based hard mask material. Optionally, the hard mask may as shown be preceded by deposition of an adhesion layer 32 (e.g., of TiN or TaN).

In Fig. 1e, the hard mask 34 has been patterned into a pattern or lines or mandrels. The line pattern may typically be a pattern of unidirectional and parallel lines with a regular pitch. The line pattern of the hard mask 34 has subsequently been transferred into the workpiece 10 by etching, thereby forming a corresponding pattern of initial metal lines 40 separated by trenches 42 in the first and second metal layers 14, 18 and the interfacial layer 16 of the workpiece 10. Where the bonding layer 28 and the adhesion layer 26 are present, the pattern may be transferred also into these layers. In either case, the etching is stopped on the top surface of the (formerly top-most) first interconnect level 22. Thus, each initial metal line 40 comprises a respective line (remaining portion) of the first and second metal layers 14, 18 and the interfacial layer 16, and if present, of the bonding layer 28 and the adhesion layer 26. Any suitable etching process (wet or dry) allowing direct metal etching of the workpiece 10 (e.g., Ru, Mo or W) may be used. The hard mask 34 may be patterned in a conventional manner, single patterning as well as multi patterning approaches are possible. The hard mask 34 may as shown be partially consumed during the etching. The pattern of initial metal lines 40 may as shown be aligned with the underlying vias 24.

In Fig. 1f, the hard mask 34 has been removed and ILD for an initial ILD layer 44 has been deposited to fill the trenches 42 and thus surround the initial metal lines 40 on either side. As indicated by their like fill patterns, the initial ILD layer 44 may be formed of a same material as the ILD layer 23, without loss of generality.

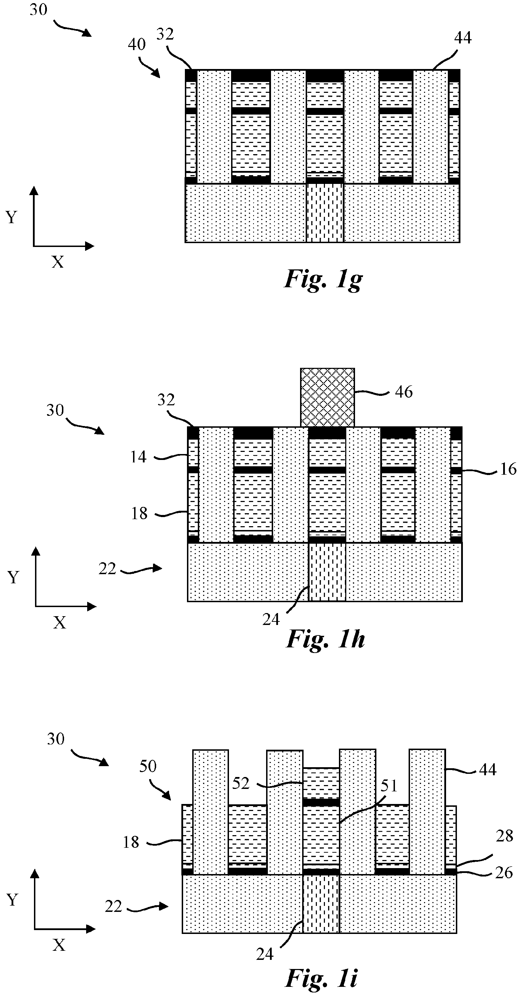

In Fig. 1g, overburden (excess) ILD has been removed from the top surface of the device structure 30 by a planarization step, for instance chemical mechanical polishing (CMP). The planarization may as shown be stopped on the adhesion layer 32 (if present). However, it is also possible to remove also the adhesion layer 32 during the planarization.

In Fig. 1h, a pattern of mask pillars 46 have been formed over the device structure 30. If the adhesion layer 32 has been preserved in the preceding planarization step, it may facilitate adhesion of the mask pillars 46 to the initial metal lines 40. Each mask pillar 46 defines a location for a via to be formed in the pattern of initial metal lines 40. For ease of illustration Fig. 1h only shows a single such mask pillar 46, however, corresponding mask pillars may of course be defined in each location where a via is desired. The mask pillars 46 may be formed by a lithographically patterned resist layer, or a lithographic layer stack defined by lithography and etching, as per se is known in the art.

In Fig. 1i, the initial metal lines 40 have been partially etched back (recessed) by a metal etch while masking the initial metal lines 40 in the via locations defined by the mask pillars 46. Thereby, the lines of the second metal layer 18 remain to form metal lines 51 and portions of the lines of the first metal layer 14 may be preserved to form vias 52. Each via 52 is thus formed on top of a metal line 51. The metal lines 51 and the vias 52 collectively define a second interconnect layer 50 on top of the first interconnect layer 24. At least a subset of the metal lines 51 is formed on top of, and thus in direct contact with, a via 24. During the etch back the interfacial layer 16 may provide an etch contrast and thus be used for etch stop detection during the etch back. Any conventional metal etching process allowing the initial metal lines 40 to be etched back selectively to the mask pillars 46 and the ILD layer 44 may be used.

In Fig. 1j, the trenches or gaps in the initial ILD layer 44 formed during the etch back of the initial metal lines 40 have been refilled with ILD, to cover the metal lines 51 and surround the vias 52. Overburden ILD may after deposition be removed from the device structure 30 by planarization (e.g., CMP) to provide a final "second" ILD layer 54 with a planar top surface flush with top surfaces of the vias 52. Thereby, a second interconnect level 56 comprising the second interconnect layer 50 (comprising a layer of metal lines 51 and a layer of vias 52) and the second ILD layer 54 has been formed on top of the first interconnect level 22. The first interconnect level 22 may as shown comprise Vx-1 level vias 24 (e.g., V0), while the second interconnect level 56 may comprise Mx level metal lines 51 Vx level vias 52.

Fig. 1k illustrates how the process described above may be repeated to form a third interconnect level on top of the second interconnect level 56 by forming and bonding a further workpiece 10' corresponding to the workpiece 10 to the interconnect structure of the device structure 30 formed in the preceding layer transfer and bonding process. The method may thereafter proceed as discussed above with reference to the workpiece 10, by removing the sacrificial substrate 12 from the further workpiece 10', and thereafter proceed with patterning of the workpiece 10'.

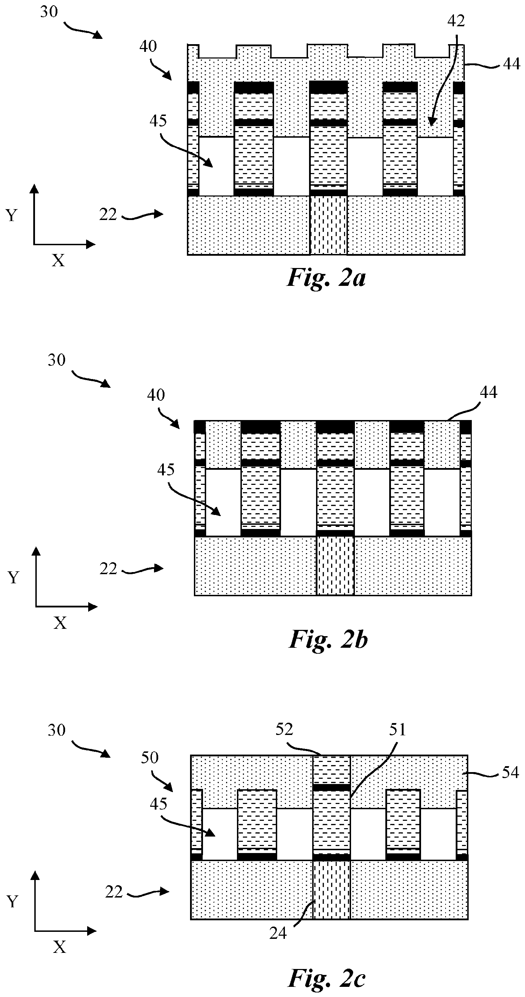

Fig. 2a-c depicts a variation to the ILD deposition in Fig. 1f-g where the ILD 44 instead of being deposited to (completely) fill the trenches 42 is deposited by pinch-off deposition, such that upper portions of trenches 42 between the patterned interconnects are filled with the ILD 44 and air gaps 45 are formed underneath. Pinch-off deposition may be realized by controlling the deposition process such that the ILD is deposited preferentially from the upper portions of the initial metal lines 40 until the upper portions of the trenches 42 are closed while air gaps 45 remain underneath.

Fig. 2c shows the resulting device structure 30 after ILD gap fill and planarization, to provide an ILD layer 54 with air gaps underneath between the metal lines 51.

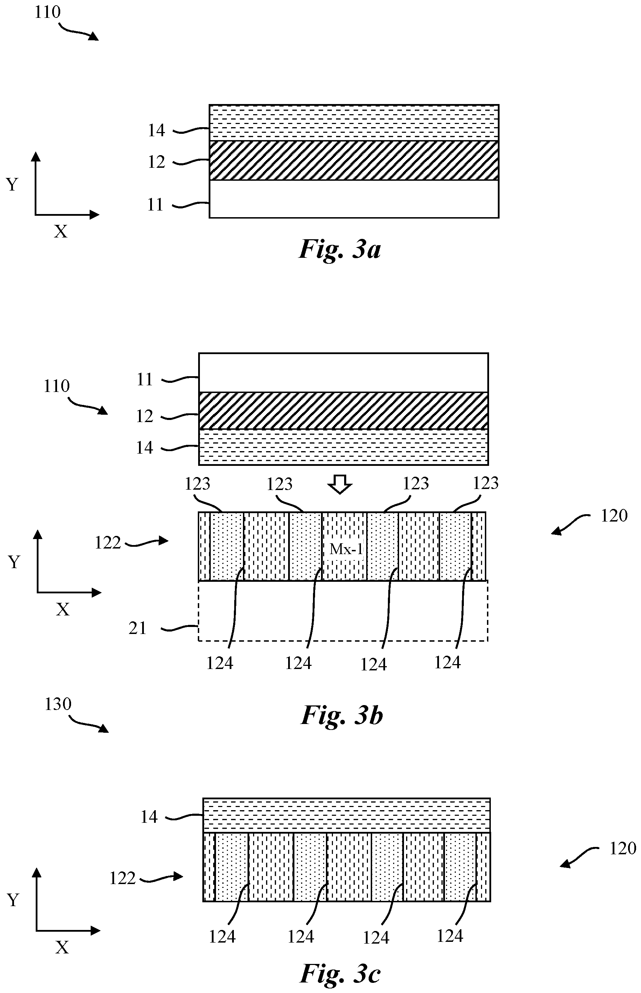

Fig. 3a-e illustrate various stages of a further method for forming aninterconnect structure. The following method may be useful where the first interconnect level of the device wafer provides a metallic surface area which is sufficiently great to allow a reliable hybrid bonding between the device wafer and an epitaxial metal layer of a workpiece.

Fig. 3a depicts a workpiece 110 that may be used for such a process. The workpiece 110 generally corresponds to the workpiece 10 of Fig. 1a, however differs by comprising only a single epitaxial first metal layer 14. Hence, the workpiece 110 is here constituted by the first metal layer 14 and any reference to the workpiece 110 may in the following be understood as a reference to the first metal layer 14, and vice versa.

In Fig. 3b, the growth wafer 11, supporting the sacrificial substrate 11 and the workpiece 110, is flipped and transferred to a top surface of a device wafer 120. The device wafer 120 generally corresponds to the device wafer 20 of Fig. 1b, however differs by the initial interconnect structure comprising a first interconnect layer 124 of metal lines (also referenced 124) surrounded by an ILD layer 123. The first interconnect layer 124 and the ILD layer 123 collectively define a first interconnect level 122 of the device wafer 120 (i.e., a top-most interconnect level of the device wafer 120).

In Fig. 3c, the workpiece 110 has been bonded to the device wafer 120, by means of a hybrid bonding (metal-to-metal and metal-to-dielectric) of the first metal layer 14 to the top surfaces of the ILD layer 123 and the metal lines of the first interconnect layer 124. Analogous to the discussion with reference to Fig. 1c, the hybrid bonding step may be preceded by a cleaning step for cleaning the surfaces of the first metal layer 14 and the first interconnect layer 124.

Subsequent to the bonding, the sacrificial substrate 12 and the growth wafer 11 may as set out above be removed from the first metal layer 14 of the workpiece 110.

Following the wafer/substrate removal step, a processed device structure 130 has been obtained, comprising the workpiece 110 (here formed by the single metal layer 14) on top of the initial device wafer 120. At this stage, an optional post-transfer anneal may be used to further improve the bonding and the crystallinity of the first metal layer 14.

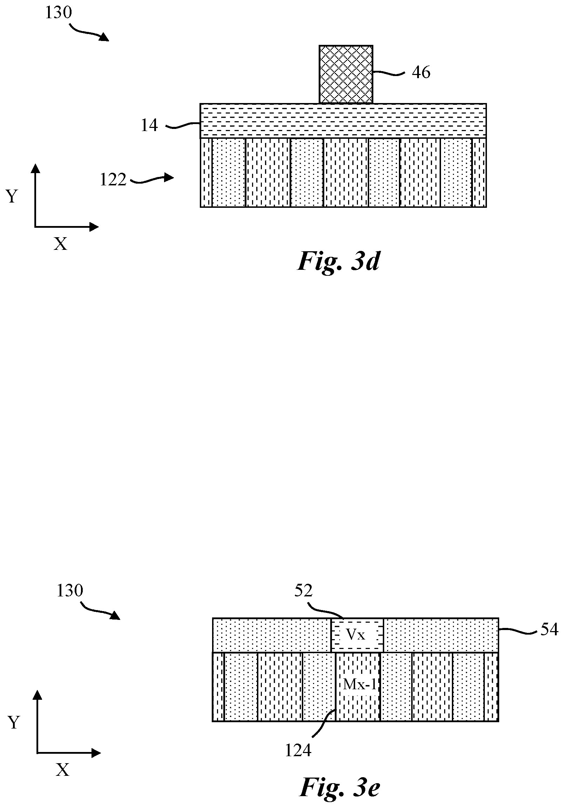

In Fig. 3d a pattern of mask pillars 46 has been formed over the device structure 30, analogous to Fig. 1h. Thus each mask pillar 46 defines a location for a via to be formed in the first metal layer 14.

In Fig. 3e, the first metal layer 14 has been patterned using the mask pillars 46 as an etch mask, thereby forming vias 52 in the first metal layer 14, on top of the metal lines 124. The vias 52 have subsequently been surrounded by a second ILD layer 54. At this stage, the layer transfer and patterning process of the above may optionally be repeated to form a further (third) interconnect layer on top of the device structure 130. The metal layer may in this case be patterned to form metal lines on top of the vias 52. As indicated in Fig. 3e, the vias 52 may be Vx level vias and the metal lines 124 may be Mx-1 level metal lines (e.g., M0).

The person skilled in the art realizes that the present invention by no means is limited to the examples described above. On the contrary, many modifications and variations are possible within the scope of the appended claims. For example, the method steps depicted in Fig. 1a-k show that a tri-layered workpiece 10 can be processed (patterning and etch back) to form metal lines 51 and vias 52 on top. However, it is possible for form a corresponding interconnect layer from a workpiece comprising only a single epitaxial workpiece metal layer, thus absent from an interfacial layer that may be used as an etch stop layer. In this case, the extent of the etch back of the workpiece metal layer may be timed to obtain metal lines of a desired height.

## Claims

1. A method for forming an interconnect structure for an integrated circuit device, the method comprising:
forming a workpiece (10) for a second interconnect layer on a sacrificial substrate (12), wherein the workpiece comprises at least a first workpiece metal layer (14) epitaxially grown on a growth surface (12a) of the sacrificial substrate (12);
bonding the workpiece (10) to an initial interconnect structure of a device wafer (20), the initial interconnect structure comprising a first interconnect layer (24) surrounded by an interlayer dielectric layer (23);
subsequent to the bonding, removing the sacrificial substrate (12) from the first workpiece metal layer (14); and
patterning the workpiece (10) comprising the first workpiece metal layer (14) to form a second interconnect layer (50) over the first interconnect layer (24).

2. The method according to claim 1, wherein the sacrificial substrate (12) is monocrystalline.

3. The method according to claim 2, wherein the sacrificial substrate (12) is an AlN substrate or an GaN/AlN substrate.

4. The method according to claim 3, wherein the sacrificial substrate (12) is epitaxially grown on a crystallographic plane with Miller indices 111 of a Si wafer (11).

5. The method according to any one of the preceding claims, wherein the first workpiece metal layer (14) is monocrystalline.

6. The method according to any one of the preceding claims, wherein the first workpiece metal layer (14) is a layer of Ru, Mo, W, Co, Ni, Cu, Rh, Ir, NiAl, PtCoO₂, or PdCoO₂.

7. The method according to any one of the preceding claims, further comprising depositing a metal bonding layer (28) over the initial interconnect structure of the device wafer (20), wherein the workpiece (10) subsequently is bonded to the metal bonding layer (28).

8. The method according to claim 7, wherein the first interconnect layer (24) and the interlayer dielectric layer (23) are exposed at a top surface of the initial interconnect structure, and the method further comprising depositing a conductive adhesion layer (26) to cover the first interconnect layer (24) and the interlayer dielectric layer (23), wherein the metal bonding layer (28) subsequently is deposited on the conductive adhesion layer (26).

9. The method according to any one of the preceding claims, wherein patterning the workpiece (10) comprises:
patterning initial metal lines (40) in the workpiece (10); and
partially etching back the initial metal lines (40) while masking the initial metal lines (40) in via locations, to form metal lines (51) and vias (52), wherein each via (52) is formed in a via location, on top of a metal line (51).

10. The method according to claim 9, wherein the workpiece (10) further comprises a layer stack of the first workpiece metal layer (14), a conductive interfacial layer (16) deposited on the first workpiece metal layer (14) and a second workpiece metal layer (18) epitaxially grown on the conductive interfacial layer (16), and wherein:
bonding the workpiece (10) to the initial interconnect structure of the device wafer (20) comprises directly bonding the second workpiece metal layer (18) to the initial interconnect structure of the device wafer (20); and
the interfacial layer (16) is used as an etch stop layer when etching back the initial metal lines (40) such that the metal lines (51) are formed in the second workpiece metal layer (18) and the vias (52) are formed in the first workpiece metal layer (14).

11. The method according to claim 10, wherein the first and second workpiece metal layers (14, 18) are formed of a same metal, and wherein, optionally, the first and second workpiece metal layers (14, 18) are monocrystalline.

12. The method according to any one of claims 9-11, wherein the first interconnect layer (24) of the device wafer (20) comprises vias, and wherein at least a subset of the metal lines (51) is formed on top of a via (24) of the first interconnect layer (24).

13. The method according to any one of claims 1-6, wherein:
the first interconnect layer (24) of the device wafer (20) comprises metal lines (124) defining a top surface of the initial interconnect structure of the device wafer (20);
bonding the workpiece (10) to the initial interconnect structure comprises bonding the first workpiece metal layer (14) to the top surface of the initial interconnect structure; and
patterning the workpiece (10) comprises patterning vias (52) in the first workpiece metal layer (14).

14. The method according to any one the preceding claims, further comprising depositing interlayer dielectrics (54) to surround the second interconnect layer (50).

15. The method according to any one the preceding claims, further comprising, subsequent to forming the second interconnect layer (50):
forming a further workpiece (10') for a third interconnect layer on a further sacrificial substrate (12), wherein the further workpiece comprises at least a first workpiece metal layer (14) epitaxially grown on a growth surface (12a) of the further sacrificial substrate (12);
bonding the further workpiece (10') to the device wafer (20);
subsequent to the bonding, removing the further sacrificial substrate (12) from the first workpiece metal layer (14) of the further workpiece (10'); and
patterning the further workpiece (10') comprising the first workpiece metal layer (14) to form the third interconnect layer on top of the second top interconnect layer (50).
